(19) Europäisches Patentamt

European Patent Office

Office européen des brevets

(11) EP 1 477 857 A1

(12) EUROPEAN PATENT APPLICATION

(43) Date of publication:
17.11.2004 Bulletin 2004/47

(51) Int Cl.7: G03F 7/20

(21) Application number: 04252717.6

(22) Date of filing: 11.05.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 13.05.2003 EP 03252966

(71) Applicant: ASML Netherlands B.V.
5504 DR Veldhoven (NL)

(72) Inventors:
• Reuhman-Huisken, Maria Elisabeth
5581 EG Waalre (NL)

• de Mol, Christianus Gerardus Maria
5691 SN Son en Breugel (NL)
• Tolsma, Hoite Pieter Theodoor
5627 HL Eindhoven (NL)

(74) Representative: Leeming, John Gerard
J.A. Kemp & Co.,
14 South Square,
Gray's Inn
London WC1R 5JJ (GB)

(54) **Method of characterising a process step and device manufacturing method**

(57) A system in which deformation of a substrate wafer is monitored during processing of the wafer is disclosed. The distortion in the substrate wafer is measured after each exposure and processing step by comparing the position of a plurality of reference marks 20 to values in a database.

Fig. 3

```
                          ┌──────────────────────┐
        S1 ──▶            │     MEASUREMENT       │
                          └──────────────────────┘
                                     │
        S2 ──▶            ┌──────────────────────┐
        AFF ─────────────▶│  EXPOSE AND DEVELOP   │
                          └──────────────────────┘
                                     │
        S3 ──▶            ┌──────────────────────┐
                          │  OVERLAY VERIFICATION │
                          └──────────────────────┘
                                     │
        S5 ──▶            ┌──────────────────────┐
        ┌──────────────┐  │   PATTERN TRANSFER    │  FF
        │ MEASUREMENT  │─▶│         S4 ──▶        │
        └──────────────┘  └──────────────────────┘
```

## Description

The present invention relates to a method of characterizing a process step and a device manufacturing method using a lithographic apparatus.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

Manufacturing a typical device by a lithographic process requires a plurality of cycles each of several steps. These include the steps of: coating the substrate with a photosensitive material, projecting an image on the photosensitive material, developing the photosensitive material and processing the substrate, which can include covering the substrate in a new layer of material. One of the problems encountered with the lithographic process is that successive layers are not accurately imaged on top of each other so that there is a so-called overlay error. In order to avoid proceeding onto the subsequent steps when an overlay error already exists which would be detrimental to the component's performance, after each cycle the overlay error is measured. If the overlay error is too large then the most recent layer can be removed and that cycle repeated before proceeding onto the next cycle.

In order to minimize the overlay errors, substrates are provided with a plurality of reference marks so that the exact position of the substrate on a substrate table in a projection apparatus may be measured prior to the exposure step. In this way it is possible to maximize the accuracy of the exposure step because the relative positions of the substrate, the previously applied patterned layer and the mask in the lithographic apparatus are known.

Another problem with multi-cycle lithographic processes is the deformation of the substrate which can occur with the application of particular layers and/or particular patterns. Deformation includes, for example, topographic 3 dimensional deformation, deformation of the reference marks (shape or depth) or variation of layer properties or thicknesses deposited on the wafer.

Chemical mechanical polishing (CMP) is notorious for causing deformation of the substrate. With the use of substrate wafers with a diameter of 300mm or more, it is expected that wafer deformation will become an even more important factor. In order to minimize deformation, the processes need to be kept as uniform as possible over the whole area of the substrate. Deformation of the substrate wafer can lead to errors in the imaging of the wafer resulting in the need to repeat a particular step. Also, during the development of a process for a particular component manufactured by lithography the process is optimized to minimize, or at least keep within limits, the amount of substrate deformation. The reduction of overlay errors or errors as a result of substrate deformation or at least early detection of such errors leads to improved yield.

EP 0 794 465 A2 discloses a lithographic method in which an alignment correction value is derived from overlay measurements made on a selection of wafers from a lot and used in the exposure of other wafers in the same or a subsequent lot.

US 2002/012482 A1 discloses a method for manufacturing and using reference wafers in a fab to determine wafer stage registration performance.

US 5,252,414 discloses a method of evaluating a resist coating in which a second resist layer is applied on top of a first patterned resist layer. Overlay accuracy between patterns in the first and second resist layer gives a quantitative evaluation of the resist coating.

US 5,863,680 discloses a device manufacturing method in which information relating overlay errors between earlier process layers and exposure conditions is used to correct the alignment of subsequent layers.

It is an object of the present invention to provide a device manufacturing method which improves yield.

According to an aspect of the invention, there is provided a method of characterizing a process step performed on a substrate having thereon a plurality of reference marks, the method comprising:

- exposing a pattern representing a layer of functional parts of a device onto a photosensitive layer provided on said substrate to imprint a latent pattern;
- developing said latent pattern in said photosensitive layer to reveal said pattern;
- processing said substrate;
- measuring the relative positions of said reference marks on said substrate; and
- comparing the results of said measuring step with reference information relating to nominal positions of said reference marks to characterize said process step.

With this method substrate deformation during manufacture can be monitored without a reduction in throughput because the step of measuring the relative positions of the reference marks takes less time than the exposure step and in some cases needs to be carried out in any case in order to gauge the positioning of the substrate relative to the protocol which is used in the exposing step. The method allows the effects of process steps carried out on other tools to be monitored in the lithographic apparatus used for patterning.

If the result of the comparison is greater than a predetermined maximum, an operator may be alerted. This can improve yield for the customer as substrates which have deformed beyond a certain amount will be rejected before further exposing, developing and processing steps are carried out. Furthermore, during development of a multi-step process for the manufacture of a device using lithography, those steps which cause unacceptable substrate deformation can be identified at an early stage. With the invention, it is also possible to alert a user of the apparatus if the apparatus drifts such that sub-standard substrates are being manufactured.

The information may comprise any kind of data, for example raw position data, raw sensor data indicative of the substrate markers, calculations from the data, such as magnification, translation, rotation or differences of individual measurements with respect to a reference grid described by parameters, each relating to the substrate in general and/or the particular layer of concern as well as statistical measures.

If the information stored in the database is results of previous measuring steps, it is possible to accept or reject a substrate dependent on the deviation from the average measurement results or to highlight a change in processing conditions or a problem with the apparatus or processing conditions. Preferably in such a case the information is results of previous measuring steps on substrates of the same batch of substrates so that it is known that those substrates have all undergone the same processing. Of course, other comparisons may be made. For example, the information in the database used for the comparison may be values from the same layer in a different batch of wafers. A batch or lot is a set of wafers subjected to the same steps.

Preferably, the method comprises the step of automatically storing the result of the said measuring and/or comparing steps in said database so that a history of results is saved. This may be useful as a diagnosis tool for engineers investigating a particular process with a view to optimizing yield.

It is also possible to control the exposing step dependant on the results of the comparing step of the preceding cycle. Thus, the exposing step can be controlled to take account of the deformation of the substrate which has been measured, thereby to ensure that the exposing step exposes the substrate in such a way to account for the deformation present in the substrate.

According to a further aspect of the invention there is provided a device manufacturing method comprising:

- providing a substrate;
- providing a projection beam of radiation using an illumination system;
- using patterning means to impart the projection beam with a pattern in its cross-section, said pattern including alignment marks and functional parts of a device layer;
- projecting the patterned beam of radiation onto a target portion of the substrate to form a latent pattern;
- developing said latent pattern to reveal said pattern;
- processing said substrate;
- measuring the relative positions of said reference marks on said substrate; and
- comparing the results of said measuring step with reference information relating to nominal positions of said reference marks to characterize said process step.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/ or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which:

Figure 1 depicts a lithographic projection apparatus according to an embodiment of the invention;

Figure 2 depicts a substrate wafer with a typical pattern of reference marks;

Figure 3 is a schematic illustration showing the various steps of the method according to an embodiment of the invention; and

Figure 4 shows the use of cycle fingerprint data and substrate data to make predictions.

In the Figures, corresponding reference symbols indicate corresponding parts.

Embodiment 1

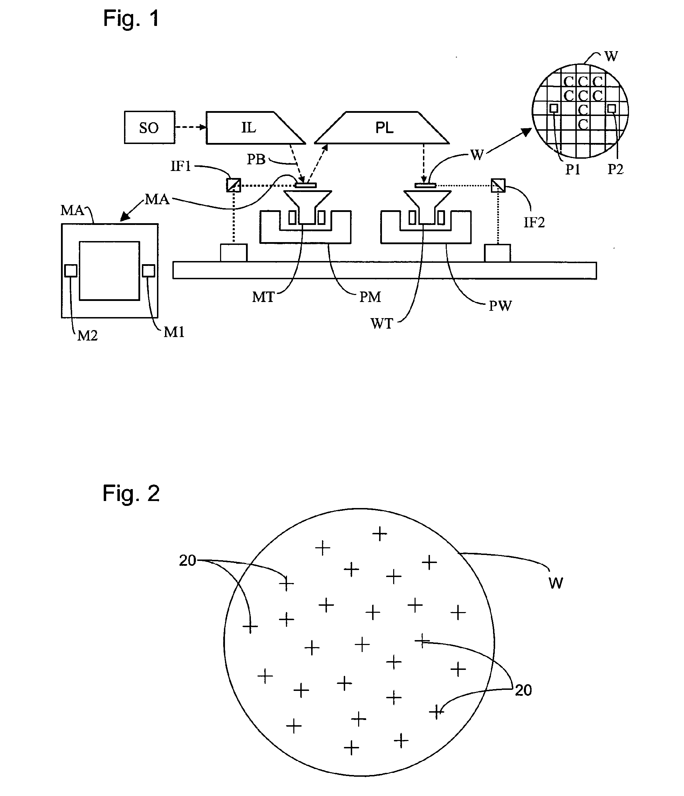

Figure 1 schematically depicts a lithographic apparatus according to a particular embodiment of the invention. The apparatus comprises:

- an illumination system (illuminator) IL for providing a projection beam PB of radiation (e.g. UV or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as $\sigma$-outer and $\sigma$-in-

ner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fme positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:

1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

Figure 2 illustrates, in plan, a substrate W with a plurality of reference marks 20 which have been applied on the upper surface. In a dual stage lithographic projection apparatus the number of a reference marks 20 might be in the region of 25 per substrate W. There is plenty of time in the measurement step when using such apparatus for the precise measurement of the relative positions of each of the reference marks 20 on the substrate W.

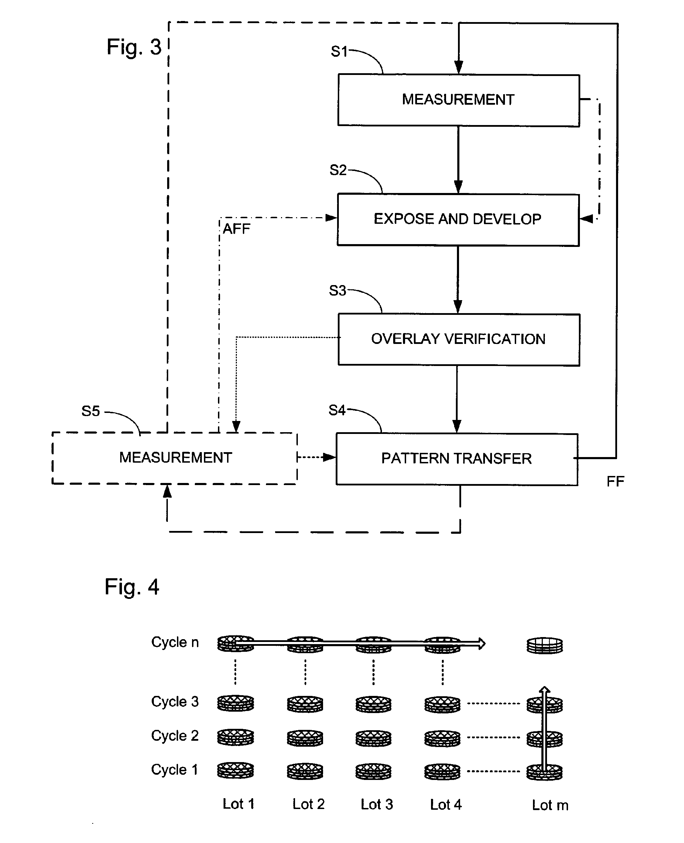

Figure 3 illustrates the steps of the method. The first step of the method is a measurement step S1, in which the relative positions of each of the reference marks 20 on the substrate W are measured. This step can be performed in the lithographic projection apparatus where the position of the reference marks 20 are measured in any case for substrate W to substrate table WT alignment and leveling measurement, or it can be performed in a separate machine. The machine used in the measurement step S1 could be the same machine that is used for overlay verification which measures the alignment between two consecutive layers on the substrate W. This overlay verification step S3 will be described later.

During the measurement step S1 a measuring system measures the relative positions of the plurality of reference marks 20 on the substrate W under the control of a controller. A processor is used to compare the results of the measurement S1 with information/values in a database.

Several variations of the method are possible depending on the results of the comparison between the measured results with the information stored in the database. For example, an operator alerter may be activated if the comparison reveals that the substrate W is deformed beyond predetermined limits. Or alternatively the result of the comparison may be used by the controller to control the subsequent exposure of the substrate W. In either case, the result of the measurement step and the result of the comparing step may be automatically saved in the database to help build up a history of how the substrate deformation changes during its processing and added to the information. This is useful both as a history for that particular substrate as well as for use in comparing how different substrates have deformed over time.

Following the measurement step S1 the wafer is exposed in a lithographic projection apparatus and is subsequently developed (step S2 in Figure 3). Usually the reference marks 20 are uncovered at the end of the exposure and development step S2 (or may remain covered if visible through the overlying layers) such that further measurement may be performed using those reference marks 20, including overlay verification S3 in which the overlay accuracy is assessed. The next step, S4, is a pattern transfer step which can involve the deposition of a layer on, or doping of, by, for example, ion radiation, or etching of areas of the substrate not covered by photosensitive material (i.e. removed during development). Of course, before the next exposure in the lithographic projection apparatus the position and orientation of the substrate W is measured using the reference marks 20 relative to the support structure which supports the patterning means which itself serves to pattern a projection beam generated by a radiation system to a desired pattern. The projection beam is of course projected by a projection system onto a target portion of the substrate W.

In one embodiment a feed forward loop FF is used to control the exposure step of the exposure and develop step S2 to take into account the measured deformation and the result of the comparison in step S1.

Following the exposure and development step S2, an alignment measurement step S3 is performed in which the alignment of two subsequent layers deposited on the substrate W during consecutive cycles is measured. This process ensures that, should the alignment of the latest layer to its preceding layer be unsatisfactory, that latest layer can be removed and a new layer deposited so that no unnecessary effort is expended in applying further subsequent layers to the substrate W even when the detected misalignment between layers would render such a substrate useless.

Figure 3 shows an alternative or additional measurement step S5 in which the positions of the reference marks 20 are measured relative to each other and the results are compared to information in a database. It is convenient in certain types of apparatus to perform the alignment measurement step S3 and the measurement step S5 at the same time so as to free up the lithographic projection apparatus for exposing substrates which have already been measured (shown in dotted lines). Alternatively, the measurement step S3 may be performed after step S4 but independently of step S5. A feed forward control of the exposure step S2 is also possible (labeled AFF in Figure 3). It may then only be necessary to measure a few of the reference marks 20 in step S1 for aligning the position of the substrate W relative to the mask in the projection apparatus.

The measurement, exposure, development, alignment measurement and pattern transfer steps S1, S2, S3, S4 form a cycle which is performed a plurality of times as required according to the desired structure on the substrate W. The results of each measurement step S1, S5 may be automatically stored in the database by an automatic storer. In this way a history of deformation of the substrate W may be built up during its processing. This allows process engineers to identify which of the plurality of exposure, development and process steps S2, S4 results in unallowable amounts of deformation of the substrate W.

The first measurement step before the substrate W has been exposed may be performed without a comparison to a database. In this circumstance, no deformation of the substrate W would have occurred due to exposure or process because no exposure or process has yet occurred.

In some cases it may be advantageous in the comparing step to only compare values stored in the database which come from substrates W of the same batch of substrates W. It may be that substrates of different batches react in differing ways to given exposure, development and processing steps, such that only values from the same batch of substrates would form a valid comparison. The activation of the operator alerter could indicate to the operator either a drift in the settings of the lithographic projector apparatus or a substrate W which has been subjected to too large a deformation.

The values in the database may be values of previous measuring steps S1, S5 on the particular substrate W under consideration. If a comparison shows deformation between cycles, or overall, beyond a predetermined value, the operator alerter may be activated or the exposure step S2 controlled by the controller to account for the deformation.

The controller can control the exposure step S2 to account for position offset or non-orthogonal deformation (automatically or by alerting an operator to make a manual correction) or even higher order deformations (i.e. non-linear deformations).

Figure 4 shows how fingerprint data relating to a particular cycle, cycle n, averaged over a number of lots and substrate data averaged over the substrate of a given lot, lot m, can be used to predict the results of the particular cycle on the given lot.

A statistical method of identifying discrepant substrates uses linear regression analysis based on the following model:

$$\Delta = \beta_0 + \beta_1 x + \beta_2 y + \text{residual}$$

where $\Delta$ is the difference between a measured position and the expected position in (x,y,z). In general the model fit is not perfect, which will result in a residual for each measurement. This residual can be thought of to consist of two components: a so-called *non-correctable* component and a *random* component. The non-correctable component is a constant that, by definition, cannot be described by the model applied. The random component, which may also be referred to as *measurement*

*noise,* consists of real measurement-device related noise and, for example, of randomly variation in the quality of the measurement targets.

In practice multiple linear regression is applied to a number of *entities,* where an entity might be a substrate containing multiple alignment measurements multiple substrates per batch or lot. Therefore modeling substrate data will result in a residual for each measurement position. By averaging the residuals for each measurement over all substrates an estimate is obtained of the non-correctable error of that position. In the event of a process change, an error such as a particle on the substrate table, or a layer-to-layer interaction, the pattern of the non-correctable errors will change and can readily be detected.

Whilst specific embodiments of the invention have been described above, it will be appreciated that the invention may be practiced otherwise than as described. The description is not intended to limit the invention.

**Claims**

**1.** A method of **characterizing** a process step performed on a substrate having thereon a plurality of reference marks, the method comprising:

- exposing a pattern representing a layer of functional parts of a device onto a photosensitive layer provided on said substrate to imprint a latent pattern;
- developing said latent pattern in said photosensitive layer to reveal said pattern;
- processing said substrate;
- measuring the relative positions of said reference marks on said substrate; and
- comparing the results of said measuring step with reference information relating to nominal positions of said reference marks to characterize said process step.

**2.** A method according to claim 1 wherein **characterizing** said process step comprises detecting and/or measuring any deformation of said substrate that may have occurred in said process step.

**3.** A method according to claim 1 or 2, further comprising measuring the relative positions of said reference marks on said substrate prior to said processing to obtain said reference information.

**4.** A method according to claim 1 or 2, wherein applying, exposing, developing and processing steps are carried out on a plurality of substrates in a batch, and further comprising measuring the relative positions of said reference marks on a first one of said substrates to obtain said reference information, which is then used to detect and/or measure any deformation of other substrates of said batch.

**5.** A method according to any one of the preceding claims wherein applying, exposing, developing and processing steps are carried out on a plurality of substrates; said measuring and comparing steps are carried out on one substrate and at least one parameter of a processing step carried out on a substrate after said one substrate is adjusted based upon said measuring and comparing steps.

**5.** A method according to any one of the preceding claims, further comprising:

- exposing a second pattern representing a layer of functional parts of a device onto a second photosensitive layer provided on said substrate to imprint a second latent pattern;
- developing said second latent pattern in said photosensitive layer to reveal said second pattern;
- processing said substrate;
- wherein said exposing a second pattern is controlled dependent upon the result of the comparing step of the preceding cycle.

**6.** A method according to any one of the preceding claims further comprising automatically storing the result of said measuring and/or comparing steps in a database.

**7.** A method according to any one of the preceding claims wherein processing said substrate comprises a process that transfers said pattern to said substrate.

**8.** A method according to any one of the preceding claims wherein processing said substrate comprises modifying a process layer formed on said substrate.

**9.** A method according to claim 8 wherein said processing said substrate includes a chemical mechanical polishing process.

**10.** A device manufacturing method comprising:

- providing a substrate;
- providing a projection beam of radiation using an illumination system;
- using patterning means to impart the projection beam with a pattern in its cross-section, said pattern including alignment marks and functional parts of a device layer;
- projecting the patterned beam of radiation onto a target portion of the substrate to form a latent pattern;

- developing said latent pattern to reveal said pattern;
- processing said substrate;
- measuring the relative positions of said reference marks on said substrate; and
- comparing the results of said measuring step with reference information relating to nominal positions of said reference marks to characterize said process step.

**11.** A computer program comprising code means that, when executed on a computer system, is effective to control an apparatus to carry out the steps of the method of any of claims 1 to 10.

Fig. 1

Fig. 2

Fig. 3

S1 — MEASUREMENT

S2 — EXPOSE AND DEVELOP

AFF

S3 — OVERLAY VERIFICATION

S5 — MEASUREMENT

S4 — PATTERN TRANSFER

FF

Fig. 4

Cycle n

Cycle 3

Cycle 2

Cycle 1

Lot 1    Lot 2    Lot 3    Lot 4    Lot m

**European Patent Office**

**EUROPEAN SEARCH REPORT**

Application Number

EP 04 25 2717

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 863 680 A (KAWAKUBO MASAHARU ET AL) 26 January 1999 (1999-01-26) | 1-6,8-11 | G03F7/20 |
| Y | * the whole document * | 7 | |
| X | US 5 252 414 A (NOMURA NOBORU ET AL) 12 October 1993 (1993-10-12) | 1,4-8,11 | |
| Y | * abstract; figure 2 * | 7 | |
| X | US 2002/102482 A1 (HUNTER ROBERT ET AL) 1 August 2002 (2002-08-01) * paragraph [0006] * * paragraph [0009] * * paragraph [0013] * * paragraph [0157] * | 1,2,8,11 | |
| X | EP 0 794 465 A (NIPPON ELECTRIC CO) 10 September 1997 (1997-09-10) * the whole document * | 1-6,8-11 | |
| A | US 2002/080364 A1 (MONSHOUWER RENE ET AL) 27 June 2002 (2002-06-27) * paragraph [0001] - paragraph [0007] * | 1-11 | TECHNICAL FIELDS SEARCHED (Int.Cl.7) G03F |

The present search report has been drawn up for all claims

| Place of search | Date of completion of the search | Examiner |
|---|---|---|
| Munich | 26 August 2004 | van Toledo, W |

EPO FORM 1503 03.82 (P04C01)

## ANNEX TO THE EUROPEAN SEARCH REPORT
## ON EUROPEAN PATENT APPLICATION NO.

EP 04 25 2717

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2004

| Patent document cited in search report | | Publication date | Patent family member(s) | | Publication date |
|---|---|---|---|---|---|
| US 5863680 | A | 26-01-1999 | JP | 9115817 A | 02-05-1997 |
| US 5252414 | A | 12-10-1993 | JP | 2112526 C | 21-11-1996 |
| | | | JP | 4101412 A | 02-04-1992 |
| | | | JP | 8028321 B | 21-03-1996 |
| US 2002102482 | A1 | 01-08-2002 | US | 2004157142 A1 | 12-08-2004 |
| | | | US | 2003202174 A1 | 30-10-2003 |
| | | | US | 2002071112 A1 | 13-06-2002 |
| | | | US | 2002105649 A1 | 08-08-2002 |
| EP 0794465 | A | 10-09-1997 | JP | 2839081 B2 | 16-12-1998 |
| | | | JP | 9246151 A | 19-09-1997 |
| | | | EP | 0794465 A2 | 10-09-1997 |
| | | | KR | 249256 B1 | 15-03-2000 |
| | | | US | 5989762 A | 23-11-1999 |
| US 2002080364 | A1 | 27-06-2002 | EP | 1348150 A1 | 01-10-2003 |
| | | | WO | 02052351 A1 | 04-07-2002 |
| | | | JP | 2004517477 T | 10-06-2004 |
| | | | TW | 526573 B | 01-04-2003 |

EPO FORM P0459

For more details about this annex : see Official Journal of the European Patent Office, No. 12/82